# EUROPEAN PATENT APPLICATION

(11) **EP 4 769 371 A1**
(43) Date of publication of application: **01.07.2026**
(21) Application number: 25755252.1
(22) Date of filing: 13.02.2025
(51) Int. Cl.: G09F 9/302, H01L 25/075, H10H 29/14, G09F 9/33

(54) **DISPLAY DEVICE AND ASSEMBLING METHOD THEREFOR**

(30) Priority: 14.02.2024 KR 20240021254
(71) Applicant: Samsung Electronics Co., Ltd, Suwon-si, Gyeonggi-do 16677 (KR)
(72) Inventor: KIM, Dowan, Suwon-si, Gyeonggi-do 16677 (KR); KIM, Kiwoong, Suwon-si, Gyeonggi-do 16677 (KR); PARK, Minkyu, Suwon-si, Gyeonggi-do 16677 (KR); PARK, Chiun, Suwon-si, Gyeonggi-do 16677 (KR)
(74) Representative: Appleyard Lees IP LLP
(86) International application number: PCT/KR2025/002170
(87) International publication number: WO 2025/174105

(57) **Abstract**

A display apparatus includes a through hole panel, a mounting module including a plurality of light emitting diodes (LEDs) and disposed to oppose the through hole panel, and a plurality of supporting reinforcement parts including a first portion of one or more supporting reinforcement parts disposed in a first direction and in contact with the through hole panel, and a second portion of one or more supporting reinforcement parts disposed in a second direction and in contact with the mounting module. The first portion and the second are configured to adjust a spacing distance between the through hole panel and the mounting module.

## Description

### BACKGROUND

### 1. Field

The disclosure relates to a display apparatus and an assembly method thereof.

### 2. Description of Related Art

Display apparatuses are output apparatuses that provide various images which a user can identify with the naked eye. Recently, there has been a growing need an increased demand for a large-scaled display apparatus that is useable not only indoors, but also in various outdoor environments such as, but not limited to, a park or a plaza.

The display apparatus described above may be manufactured in a method in which a plurality of display modules are assembled in order to implement a large sized screen.

### SUMMARY

According to an aspect of the disclosure, a display apparatus includes a through hole type panel, a mounting module including a plurality of light emitting diodes (LEDs) and disposed to oppose the through hole type panel, and a plurality of supporting reinforcement parts including a first portion of one or more supporting reinforcement parts disposed in a first direction and in contact with the through hole type panel, and a second portion of one or more supporting reinforcement parts disposed in a second direction and in contact with the mounting module. The first portion and the second are configured to adjust a spacing distance between the through hole type panel and the mounting module.

According to one or more embodiments of the disclosure, an assembly method of a display apparatus includes assembling a mounting module by mounting a substrate on which a plurality of light emitting diodes (LEDs) is arranged on a base panel, and assembling a through hole type panel with the mounting module, and the mounting module includes the plurality of LEDs arranged on the substrate and a plurality of supporting reinforcement parts, and the plurality of supporting reinforcement parts contacts is configured to, based on the mounting module and the through hole type panel being assembled for the plurality of LEDs to arranged in the plurality of through holes, contact with a bottom surface of the through hole type panel from one side of the plurality of LEDs, and space apart the substrate and the through hole type panel by a predetermined spacing distance.

### BRIEF DESCRIPTION OF THE DRAWINGS

FIG. 1 is a perspective view illustrating a coupled state of a display apparatus according to one or more embodiments of the disclosure;
FIG. 2 is an exploded perspective view illustrating a disassembled state of a display apparatus according to one or more embodiments of the disclosure;
FIG. 3 is a cross-sectional view schematically illustrating a cross-section of a display apparatus according to one or more embodiments of the disclosure;
FIG. 4 is a cross-sectional view schematically illustrating a cross-section of a display apparatus according to one or more embodiments of the disclosure;
FIG. 5 is a cross-sectional view schematically illustrating a cross-section of a display apparatus according to one or more embodiments of the disclosure;
FIG. 6 is a cross-sectional view schematically illustrating a cross-section of a display apparatus according to one or more embodiments of the disclosure;
FIG. 7 is a cross-sectional view schematically illustrating a cross-section of a display apparatus according to one or more embodiments of the disclosure;
FIG. 8 is a cross-sectional view schematically illustrating a cross-section of a display apparatus according to one or more embodiments of the disclosure;
FIG. 9 is a cross-sectional view schematically illustrating a cross-section of a display apparatus according to one or more embodiments of the disclosure;
FIG. 10 is a plane view illustrating a through hole type panel of a display apparatus according to one or more embodiments of the disclosure;
FIG. 11 is a plane view illustrating a state in which an LED is positioned on a through hole type panel of a display apparatus according to one or more embodiments of the disclosure;
FIG. 12 is a view illustrating a partially enlarged through hole type panel of a display apparatus according to one or more embodiments of the disclosure;
FIG. 13 is a view illustrating a bottom surface of a through hole type panel of a display apparatus according to one or more embodiments of the disclosure;
FIG. 14 is a plane view illustrating a substrate of a display apparatus according to one or more embodiments of the disclosure;
FIG. 15 is a view illustrating a partially enlarged substrate of a display apparatus according to one or more embodiments of the disclosure;
FIG. 16 is a perspective view illustrating a bottom surface of a substrate of a display apparatus according to one or more embodiments of the disclosure;
FIG. 17 is a perspective view illustrating a top surface of a base panel of a display apparatus according to one or more embodiments of the disclosure;
FIG. 18 to FIG. 19 are plane views illustrating a bottom surface of a base panel of a display apparatus according to one or more embodiments of the disclosure;
FIG. 20 is a flowchart sequentially illustrating a display apparatus assembly method according to one or more embodiments of the disclosure;
FIG. 21 to FIG. 25 are views schematically illustrating a cross-section of a display apparatus according to one or more embodiments of the disclosure;
FIG. 26 is a view illustrating a portion of a substrate of a display apparatus according to one or more embodiments of the disclosure;
FIG. 27 is a view illustrating a portion of a substrate of a display apparatus as a modified example according to one or more embodiments of the disclosure;
FIG. 28 is a view illustrating a portion of a substrate of a display apparatus as a modified example according to one or more embodiments of the disclosure;
FIG. 29 is a view illustrating a state of arrangement of a display apparatus according to one or more embodiments of the disclosure;
FIG. 30 is a view schematically illustrating a substrate of a display apparatus according to one or more embodiments of the disclosure;
FIG. 31 is a view schematically illustrating a state in which a base panel and a substrate of a display apparatus are positioned according to one or more embodiments of the disclosure;
FIG. 32 and FIG. 34 are views illustrating a coupled state of a base panel, a substrate, and a through hole type panel while a supporting reinforcement part is missing;
FIG. 35 is a view illustrating a state in which visibility of a display apparatus varies according to FIG. 34; and
FIG. 36 is a view illustrating a state in which visibility of a display apparatus is uniform according to one or more embodiments of the disclosure.

### DETAILED DESCRIPTION

Embodiments described in the disclosure and configurations illustrated in the drawings are merely one or more example embodiments, and there may be various modifications that can substitute the embodiments and drawings of the disclosure at the time the present application was filed.

Same reference numerals or symbols presented in each drawing of the disclosure may indicate components or elements which perform substantially the same functions.

Terms used in the disclosure have been merely used to describe an embodiment, and is not intended to limit the embodiments described herein. A singular expression includes plural expressions, unless otherwise specified. It is to be understood that terms such as "form" or "include" are used herein to designate a presence of a characteristic, number, step, operation, element, component, or a combination thereof, and not to preclude a presence or a possibility of adding one or more of other characteristics, numbers, steps, operations, elements, components or a combination thereof.

Terms that include ordinal numbers such as 'first' or 'second' used in the disclosure may be used in describing various elements, but the elements are not to be limited by the terms, and the terms may be used only for the purpose of distinguishing one element from another element. For example, without exceeding the scope of protection of the disclosure, a first element may be designated as a second element, and likewise, the second element may be designated as the first element. The term such as "and/or" may include a combination of a plurality of related and described items or any item from among the plurality of related and described items.

Terms such as, for example, and without limitation, 'front surface,' 'rear surface,' 'top surface,' 'bottom surface,' 'side surface,' 'left side,' 'right side,' 'upper part,' 'lower part,' 'area,' and the like used in the disclosure may be defined based on the drawings, and forms and locations of each element are not limited by these terms.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, when an element or layer is referred to as "covering" or "surrounding" another element or layer, the element or layer may cover at least a portion of the other element or layer, where the portion may include a fraction of the other element or may include an entirety of the other element.

Reference throughout the disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout the present disclosure may, but do not necessarily, all refer to the same embodiment. The embodiments described herein are example embodiments, and thus, the present disclosure is not limited thereto and may be realized in various other forms.

It is to be understood that the specific order or hierarchy of blocks in the processes/flowcharts disclosed are an illustration of exemplary approaches. Based upon design preferences, it is understood that the specific order or hierarchy of blocks in the processes/flowcharts may be rearranged. Further, some blocks may be combined or omitted. The accompanying claims present elements of the various blocks in a sample order, and are not meant to be limited to the specific order or hierarchy presented.

As used herein, a supporting reinforcement part 130 may function to adjust positions, distance, or the like between a through hole type panel 110 and a mounting module 120 from among configurations that configure a display apparatus 100

In the disclosure, the a configuration that functions as a supporting reinforcement part 130 may be referred to by various designations such as, for example, and without limitation, a mounting part, a supporting part, a separating space adjusting part, a separating state adjusting part, or the like.

As described below, the through hole type panel 110 and the mounting module 120 may each have different degrees of flatness and/or bent states (hereinafter, referred to as an "abnormal state"). Accordingly, a coupling state between the above through hole type panel and the mounting module may exceed that of a uniform coupling state.

The supporting reinforcement part 130 described above may function to correspond to the problematic phenomenon described above abnormal state. More specifically, For example, at least any one from among a first structure 1111 and a second structure 1112 of the a through hole type panel 110 may have biased indentations, and protrusions, and/ or the like that may attribute to the above-described abnormal state.

Based on the above, each of a plurality of light emitting diodes (LEDs) 1221 positioned in at least a portion of first through holes H1 of the through hole type panel 110 may have a visibility difference generated between one another. In such an example, The supporting reinforcement part 130 may function such that the visibility difference between plurality of LEDs 1221 may be resolved and the plurality of LEDs may have a uniform visibility between one another.

In some embodiments, the mounting module 120 may be included with a plurality of configurations such as, but not limited, a substrate 122 and a base panel 121. Specifically, the supporting reinforcement part 130 may have the visibility difference resolved through securing a spacing distance in terms of an inter-relationship between the through hole type panel 110, the base panel 121, and the substrate 122 described above. The resolving of the visibility difference for the plurality of LEDs 1221 described above may be carried out for at least any one state from among an emissive state and a non-emissive state of the plurality of LEDs 1221.

That is, even if the different degrees of flatness, bent states, other deformations, or the like of each of the mounting module 120, the substrate 122, the base panel 121, or the like are generated at respective manufacturing time-points or after a time-point after manufacturing, the spacing states between the assembled configurations that attribute to the above-described abnormal states may be adjusted to a predetermined range at a time-point at which a coupling between one another occur.

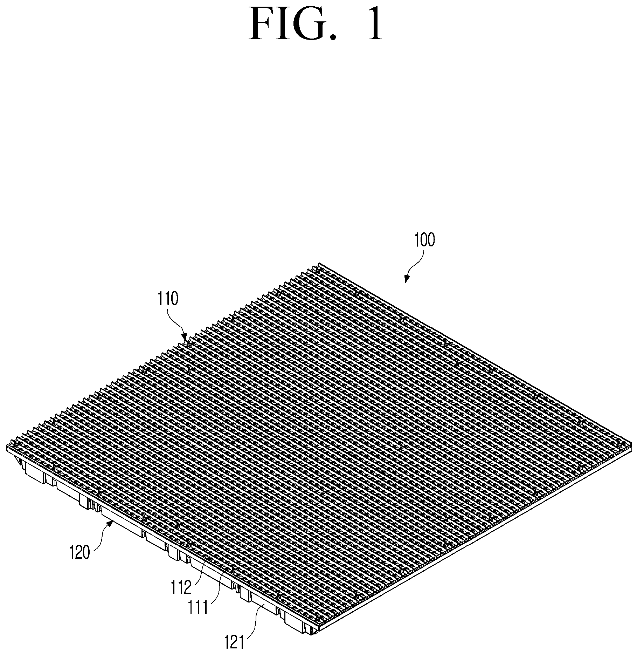

A display apparatus according to one or more embodiments is described below with reference to the accompanying drawings. FIG. 1 is a perspective view illustrating a coupled state of the display apparatus 100 according to one or more embodiments of the disclosure.

Referring to FIG. 1 to FIG. 3, the display apparatus 100 may include the through hole type panel 110, the mounting module 120, and the supporting reinforcement part 130. The through hole type panel 110 of the display apparatus 100 may include a plurality of first through holes H1, and a body 111 in which a separate through hole is formed for assembly with other configurations. The body 111 of the through hole type panel 110 may be provided in a polygonal or a circular panel type. However, the disclosure is not limited in this regard, and the body 111 may be provided in other shapes.

Here, the body 111 may include the first structure 1111 and the second structure 1112. The plurality of first through holes H1 may provide a zone capable of receiving a plurality of LEDs 1221 that may be arranged in the mounting module 120, and the first structure 1111 and the second structure 1112 may correspond to structures which may be arrayed in a horizontal direction and a vertical direction so as to be adjacent with the plurality of LEDs 1221.

The first and second structures 1111 and 1112 described above may be configured as separate structures from each other, however, the disclosure is not limited thereto, For example, the first and second structures 1111 and 1112 may be formed into an integral structure which may surround the plurality of first through holes H1.

The mounting module 120 of the display apparatus 100 may include the substrate 122 and the base panel 121. The base panel 121 may be a configuration that may be assembled with the through hole type panel 110 while supporting the substrate 122.

The substrate 122 of the mounting module 120 may be mounted with the plurality of LEDs 1221. Further, in addition to the plurality of LEDs 1221, the supporting reinforcement part 130 may be arranged at a top surface of the substrate 122 together therewith. The mounting module 120 may be assembled, with the plurality of LEDs 1221 and the supporting reinforcement part 130 arranged, to oppose with the through hole type panel 110.

Based on the assembly described above, a portion in one direction of the supporting reinforcement part 130 of the display apparatus 100 may contact the through hole type panel 110, and a portion in the other direction thereof may contact the substrate 122 of the mounting module 120 of the mounting module 120.

In an example, if the through hole type panel 110 and the mounting module 120 are assembled in a vertical direction, the portion in one direction of the supporting reinforcement part 130 may become a top surface, and the portion in the other direction thereof may become a lower surface. The supporting reinforcement part 130 described above may perform a structural function for adjusting a spacing distance between the opposing through hole type panel 110 and the mounting module 120.

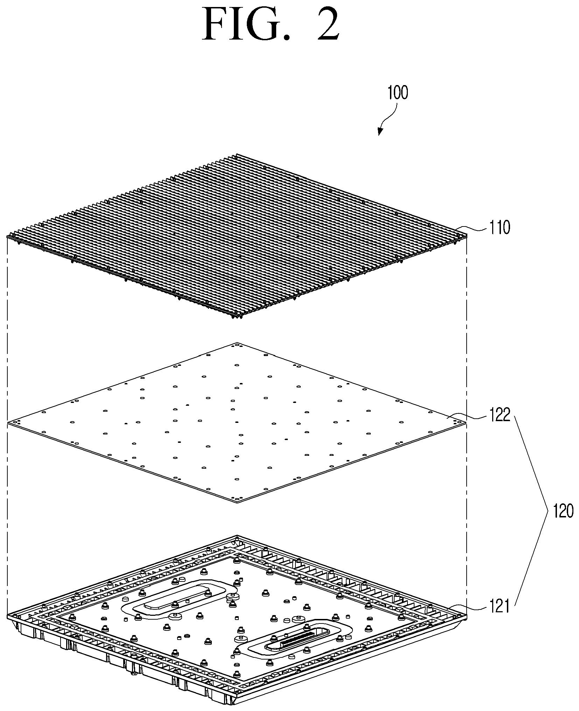

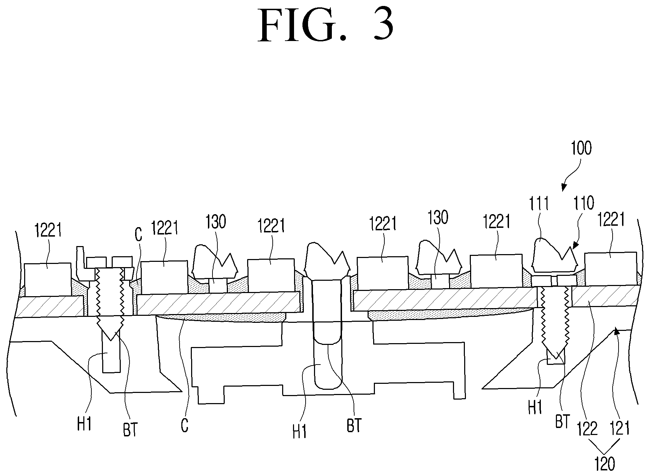

FIG. 2 is an exploded perspective view illustrating a disassembled state of a display apparatus according to one or more embodiments of the disclosure. FIG. 3 is a cross-sectional view schematically illustrating a cross-section of the display apparatus 100, according to one or more embodiments of the disclosure.

Referring to FIG. 2 and FIG. 3, the substrate 122 of the mounting module 120 may be mounted with the plurality of LEDs 1221. The base panel 121 of the mounting module 120 may perform, using the through hole type panel 110 as a medium, a structural function for receiving and fixing the substrate 122 inside thereof.

Here, the substrate 122 may be and/or include a substrate 122 of a rigid and/or substantially rigid type. In some embodiments, the substrate 122 may be and/or may include a substrate 122 of a flexible type. The first structure 1111 and the second structure 1112 on the body 111 of the through hole type panel 110 may be provided such that an intersecting direction is positioned therebetween.

Further, through holes may be formed in the plurality of LEDs 1221 on the body 111, and the through holes described above may include the plurality of first through holes H1, at least a portion of which corresponds to the plurality of LEDs 1221. The supporting reinforcement part 130 may be positioned between the substrate 122 of the mounting module 120 and the through hole type panel 110. The supporting reinforcement part 130 may correct the spacing distance between the substrate 122 and the through hole type panel 110 such that the distance may be set to a predetermined correction distance.

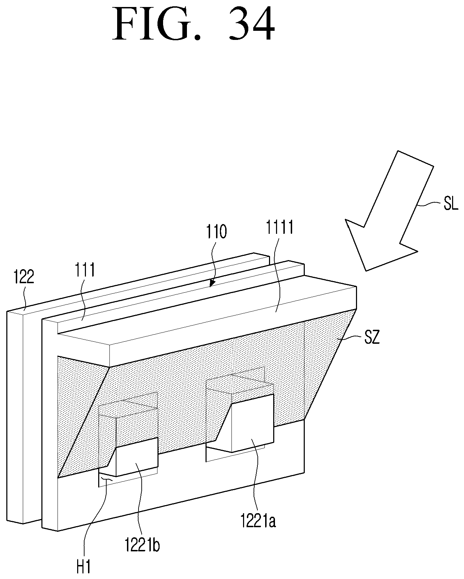

Meanwhile, assuming that there is no supporting reinforcement part which may be similar to related display apparatuses of the related art, a shadow zone (SZ) may be formed in which a shadow is cast on the plurality of LEDs 1221 due to a position difference (e.g., a height difference, or the like.) between an object (e.g., the first structure 1111 and/or the second structure 1112) and the plurality of LEDs 1221 (referring to FIG. 34). For example, if the display apparatus is used as an outdoor display apparatus that is used outdoors, variations in the shadow zone may become greater according to the direction of sun light.

In various embodiments of the disclosure, the supporting reinforcement part 130 may be used to adjust the through hole type panel 110 and the mounting module 120 to be spaced apart by a predetermined correction distance. In such a manner, a range in which the shadow zone (SZ) is formed casting a shadow on the plurality of LEDs 1221 may be adjusted to be uniform.

As a result, according to the various embodiments of the disclosure, visibility for the plurality of LEDs 1221 of the display apparatus 100 may be uniformly secured. The supporting reinforcement part 130 may be provided in the same specification with one another or in different specifications from one another on the substrate 122 for the range in which the shadow zone (SZ) is formed to be uniform between the plurality of LEDs 1221 (referring to FIG. 34). Here, the specification may be a height value, area, and the like of the supporting reinforcement part 130.

The supporting reinforcement part 130 may have various height values for the spacing distance between the substrate 122 and the through hole type panel 110 to be adjusted. In a process of manufacturing actual display apparatuses, if the through hole type panel 110 is manufactured in methods such as injection, or the like, there may be cases where bending is generated, or in which a panel may be manufactured in a state which is not flat and/or un-uniform. However, the disclosure is not limited in this regard. For example, height differences and/or other defects may be introduced into the display apparatuses during a manufacturing process due to other factors. As another example, defects may be introduced into the display apparatuses after the manufacturing process has been completed.

The defective states of the through hole type panel 110 as described may be described as a first abnormal state below. Further, the substrate 122 or the base panel 121 of the mounting module 120 may also have bending or un-uniformity generated in the manufacturing process.

Here, the above-described defective states of the substrate 122 and the base panel 121 may be respectively described as a second abnormal state and a third abnormal state below. The bent state or un-uniform state, position, and the like in the first to third abnormal states may all be different.

Accordingly, with the through hole type panel 110 and the mounting module 120 assembled, in at least a portion of the positions with bendings and un-uniformity, the above may be adjacent or in contact with each other. That is, according to a bent or un-uniform state, the spacing distance of the through hole type panel 110 and the mounting module 120 may not be uniform within a whole zone.

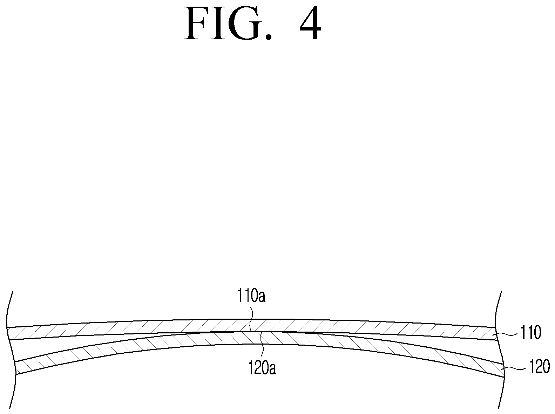

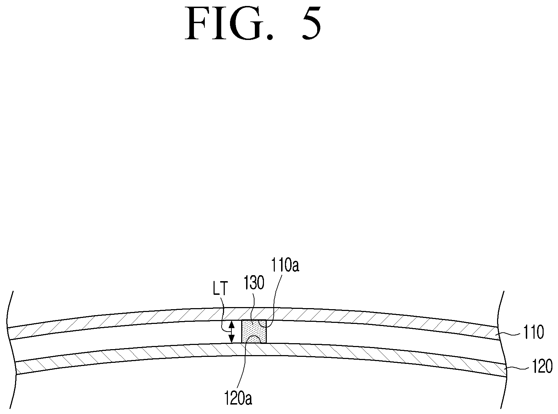

FIG. 4 is a cross-sectional view schematically illustrating a cross-section of a display apparatus according to one or more embodiments of the disclosure. FIG. 5 is a cross-sectional view schematically illustrating a cross-section of a display apparatus according to one or more embodiments of the disclosure.

In FIG. 4, although the through hole type panel 110 and the mounting module 120 have been assembled spaced apart by a certain distance, contact may be carried out in a portion of the zones due to at least any one state from among the first to third abnormal states, and being spaced apart may be shown in other zones. That is, a first opposing zone 110a of the through hole type panel 110 and a second opposing zone 120a of the substrate 122 facing with the first opposing zone 110a being positioned to be close to each other is shown.

FIG. 5 shows an example in which the supporting reinforcement part 130 is added according to an embodiment of the disclosure. The supporting reinforcement part 130 performs a function of appropriately spacing apart in-between the through hole type panel 110 and the mounting module 120 in one zone on the mounting module 120. Accordingly, a spacing distance LT may be uniformly maintained.

The through hole type panel 110, as a result, may change from the abnormal state as in FIG. 4 to a corrected state as in FIG. 5. In the disclosure, the correction state may include a state in which a spacing distance between an opposing surface of the through hole type panel 110, which opposes with the substrate 122 or the base panel 121, and the base panel 121 is formed uniformly within the predetermined range.

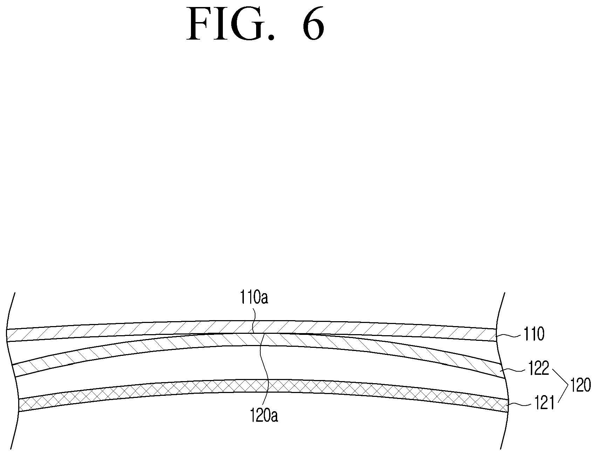

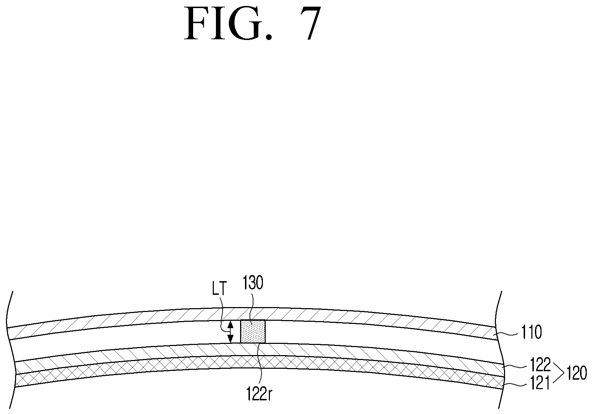

FIG. 6 is a cross-sectional view schematically illustrating a cross-section of a display apparatus according to one or more embodiments of the disclosure. FIG. 7 is a cross-sectional view schematically illustrating a cross-section of a display apparatus according to one or more embodiments of the disclosure.

Referring to FIG. 6, the base panel 121 in the mounting module 120 may be uniformly spaced apart from the through hole type panel 110, but one zone of the substrate 122 is shown as adjacent to the through hole type panel 110. In this case, a distance between the substrate 122 and the base panel 121 in the zone 120a adjacent to the through hole type panel 110 may become even further apart.

Referring to FIG. 7, the supporting reinforcement part 130 may perform a function of spacing apart the through hole type panel 110 by a certain distance on the substrate 122 which is one from among the mounting module 120 divided into a plurality of configurations. Accordingly, a distance adjustment between the substrate 122 and the base panel 121 may be performed. Through the method described above, the supporting reinforcement part 130 may correct the abnormal state.

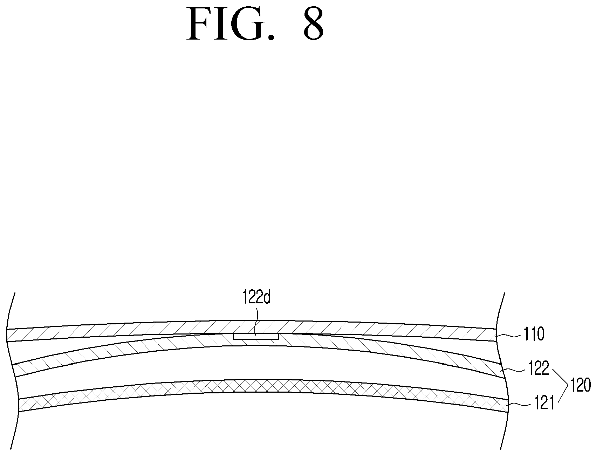

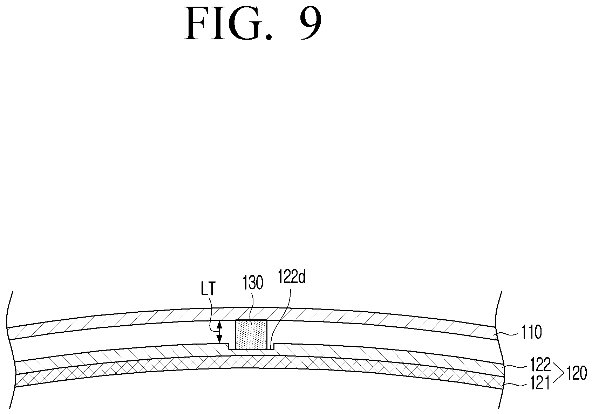

FIG. 8 is a cross-sectional view schematically illustrating a cross-section of the display apparatus 100 according to one or more embodiments of the disclosure. FIG. 9 is a cross-sectional view schematically illustrating a cross-section of a display apparatus according to one or more embodiments of the disclosure.

Referring to FIG. 8, a portion at which an indentation zone 122d is formed on the substrate 122 of the mounting module 120 being adjacent to the through hole type panel 110 is shown. Referring to FIG. 9, the supporting reinforcement part 130 may support the through hole type panel 110 from the indentation zone 122d described above to the upper part. Accordingly, the distance between the substrate 122 and the base panel 121, and the distance between the through hole type panel 110 and the substrate 122 may be uniformly adjusted.

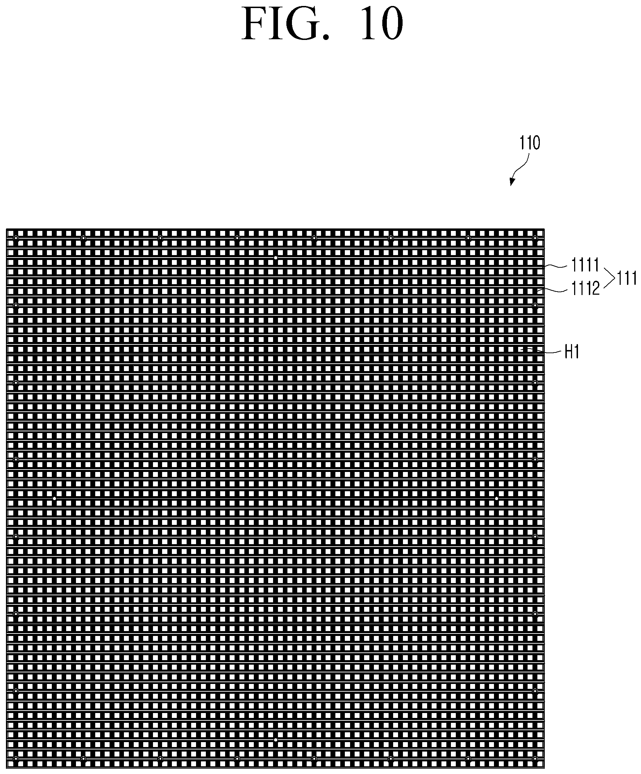

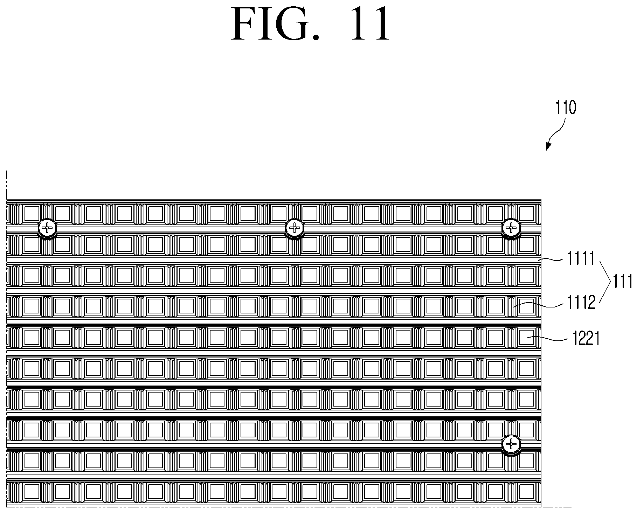

FIG. 10 is a plane view illustrating a through hole type panel of a display apparatus according to one or more embodiments of the disclosure. FIG. 11 is a plane view illustrating a state in which an LED is positioned on a through hole type panel of a display apparatus according to one or more embodiments of the disclosure.

Although in FIGS. 10 and 11, each through hole has been shown in a square shape, the disclosure is not limited in this regard. For example, shape and size of the through hole may be changed variously. Referring to FIGS. 10 and 11, the through hole type panel 110 may include a plurality of through holes H1 in a matrix form.

For convenience of description below, the through holes through which the plurality of LEDs 1221 enter in the through hole type panel 110 may be referred to as the first through holes H1. The plurality of LEDs 1221 may be provided such that at least a portion thereof corresponds with the first through holes H1 on the substrate 122. Accordingly, the plurality of LEDs 1221 described above may pass the first through holes H1 of the through hole type panel 110.

Further, the through hole type panel 110 may be mounted on the base panel 121 with the pressurized fixing method to cover the substrate 122. The supporting reinforcement part 130 may be positioned on the substrate 122, and may support the body 111 of the through hole type panel 110 to correspond to the pressurized fixing so as to be in a corrected state.

Due to the object, which is at least any one from among the first structure 1111 and the second structure 1112 of the through hole type panel 110, having biased protrusions that attribute to the above-described abnormal state, the respective LEDs 1221 which are positioned on the first through holes H1 of the through hole type panel 110 and exposed to the outside may be directly or indirectly covered.

Here, the supporting reinforcement part 130 of the display apparatus 100 may perform in aiding an extent to which the respective LEDs 1221 positioned at the first through holes H1 of the through hole type panel 110 are directly or indirectly covered by the object.

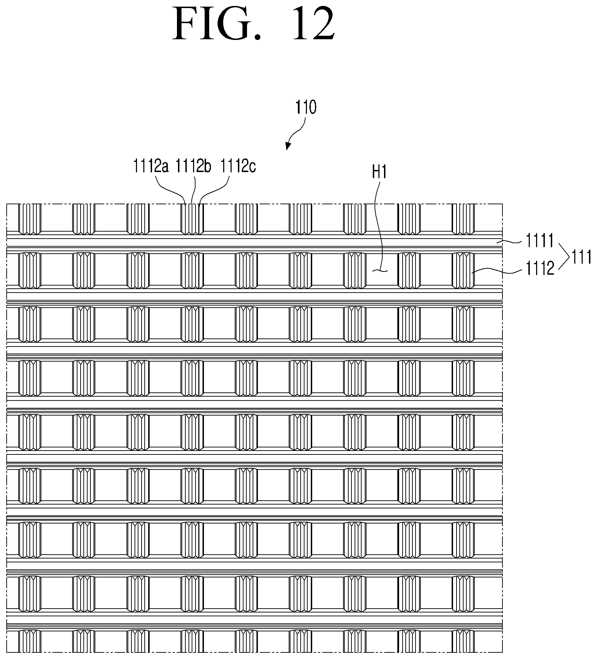

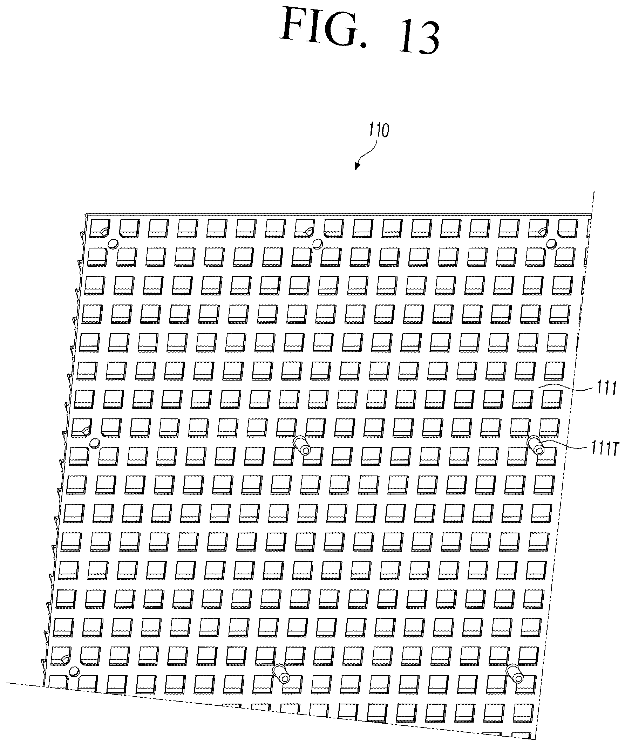

FIG. 12 is a view illustrating a partially enlarged through hole type panel of a display apparatus according to one or more embodiments of the disclosure. FIG. 13 is a view illustrating a bottom surface of a through hole type panel of a display apparatus according to one or more embodiments of the disclosure.

Referring to FIG. 12 and FIG. 13, the second structure 1112 may be provided with a first dividing part 1112a, a second dividing part 1112b, a third dividing part 1112c, and the like. Here, the first dividing part 1112a, the second dividing part 1112b, the third dividing part 1112c, and the like may be formed to be tapered toward an outer side thereof.

Here, the through hole type panel 110 may be provided with one or more insertion pins 111T at the bottom surface thereof that faces with the substrate 122. The through hole type panel 110 may be assembled on at least any one from among the substrate 122 and the base panel 121 through even insertion and the like of the insertion pins 111T described above.

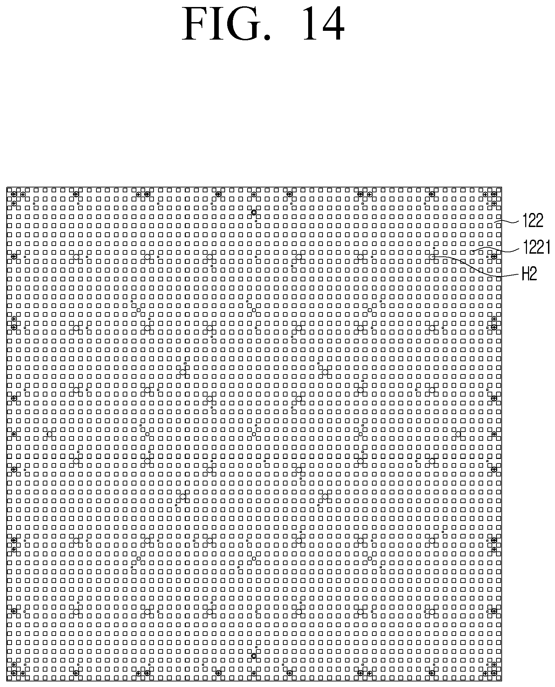

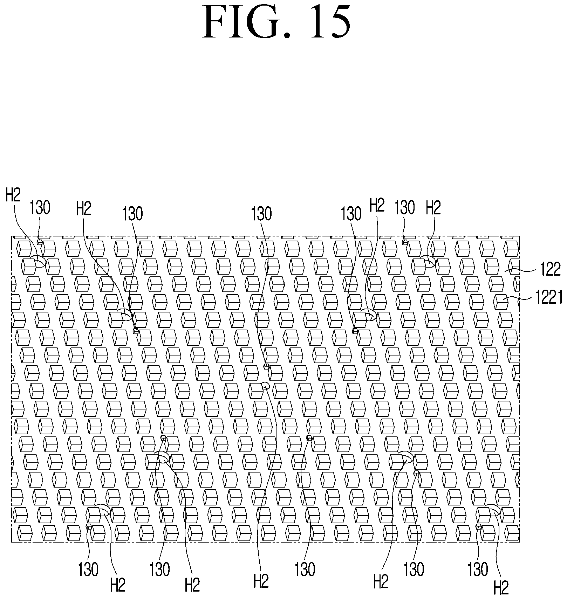

FIG. 14 is a plane view illustrating a substrate of a display apparatus according to one or more embodiments of the disclosure. FIG. 15 is a view illustrating a partially enlarged substrate of a display apparatus according to one or more embodiments of the disclosure.

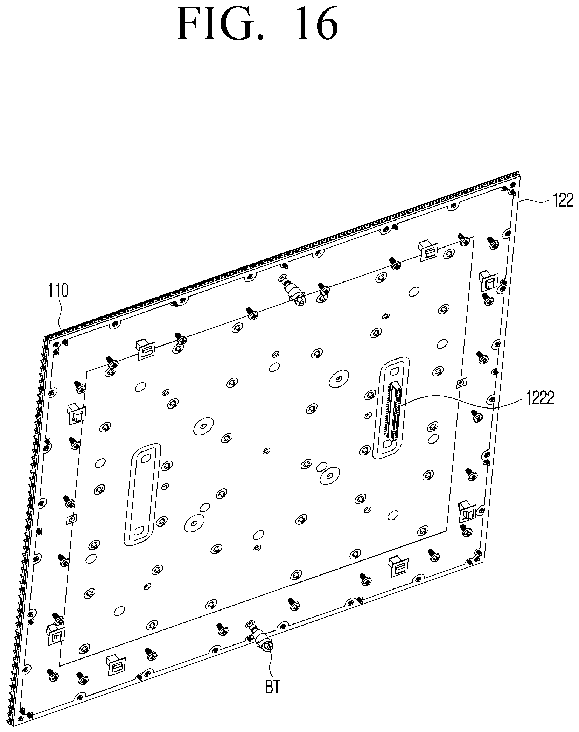

FIG. 16 is a perspective view illustrating a bottom surface of a substrate of a display apparatus according to one or more embodiments of the disclosure. Referring to FIG. 14, FIG. 15, and FIG. 16, the plurality of LEDs 1221 on the substrate 122 may be provided at predetermined distances.

For example, the supporting reinforcement part 130 may be provided between the plurality of LEDs 1221 described above. At least one from among a plurality of supporting reinforcement parts 130 may be arranged alongside at one side of the plurality of LEDs 1221 on the substrate 122 of the mounting module 120.

If the mounting module 120 and the through hole type panel 110 are assembled with each other for the plurality of LEDs 1221 to be arranged in the plurality of first through holes H1, the plurality of supporting reinforcement parts 130 may contact with the bottom surface of the through hole type panel 110 from one side of the plurality of LEDs 1221 and space apart the substrate 122 and the through hole type panel 110 by a predetermined spacing distance.

Specifically, the supporting reinforcement part 130 may be provided singularly or in plurality at a portion at which adjustment of spacing distance between the through hole type panel 110 and the substrate 122 may be needed. On the substrate 122, a plurality of through holes may be formed. For convenience of description, a portion from among the plurality of through holes formed on the substrate 122 may be referred to as second through holes H2.

The second through holes H2 of the substrate 122 may be utilized in a module assembly together with separate through holes of the through hole type panel 110 which were not shown. On the above-described substrate 122, a connector 1222 for electrical connection may be provided.

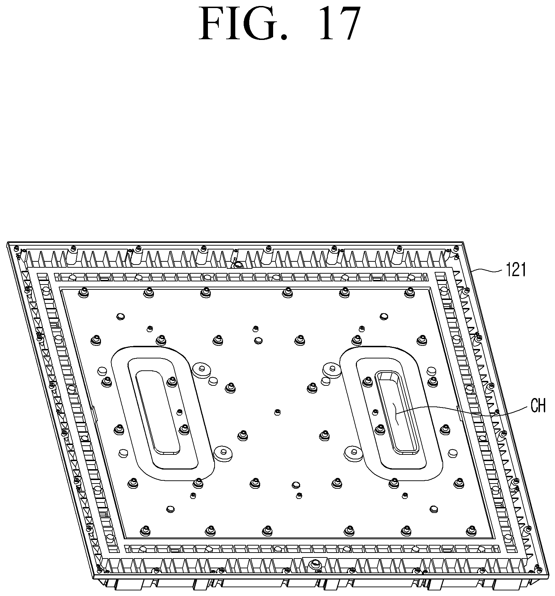

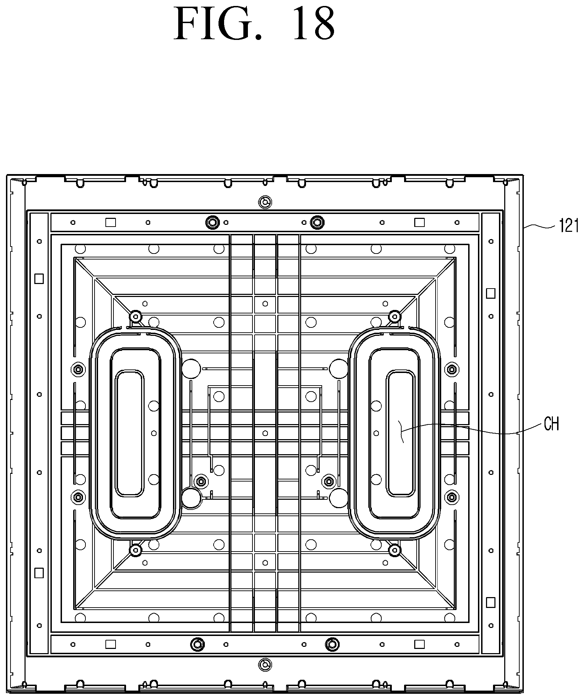

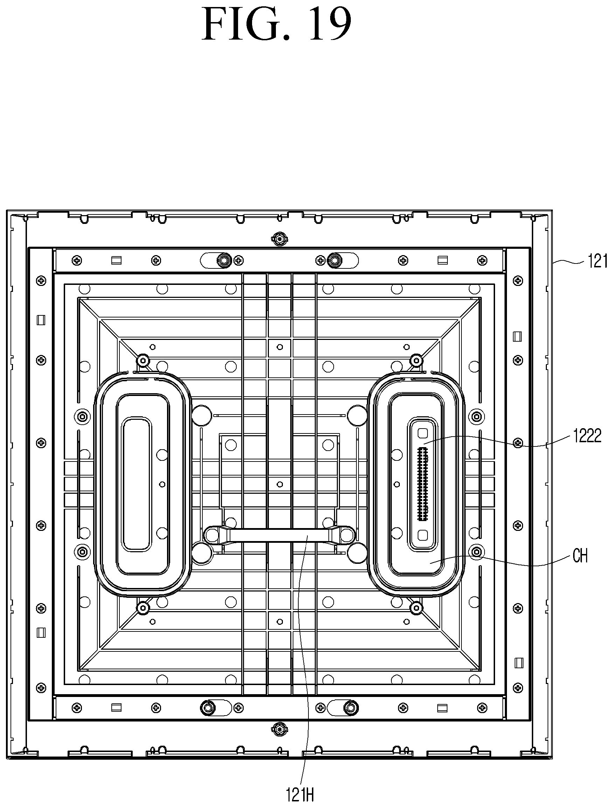

FIG. 17 is a perspective view illustrating a top surface of a base panel of a display apparatus according to one or more embodiments of the disclosure. FIG. 18 to FIG. 19 are plane views illustrating a bottom surface of a base panel of a display apparatus according to one or more embodiments of the disclosure.

Referring to FIG. 17, FIG. 18, and FIG. 18, the base panel 121 may be provided in a form for a plane that faces with the substrate 122 to receive the substrate 122 inside thereof. The base panel 121 described above may be formed with a connector insertion groove CH that corresponds to the connector 1222 of the substrate. At the bottom surface of the base panel 121, a handle 121H may be provided for physical handling.

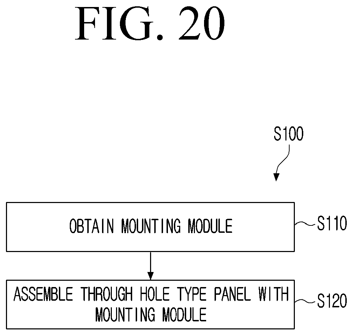

FIG. 20 is a flowchart sequentially illustrating a display apparatus assembly method according to one or more embodiments of the disclosure.

Referring to FIG. 20, the assembly method of the display apparatus (S100) may include steps S110 and S120. In step S110, the mounting module 120 may be assembled by mounting the substrate 122 on which the plurality of LEDs 1221 is arranged on the base panel 121. In step S120, the through hole type panel 110 and the mounting module 120 may be assembled.

Here, the mounting module 120 may include the plurality of LEDs 1221 arranged on the substrate 122 and the plurality of supporting reinforcement parts 130. The substrate 122 may be assembled with the through hole type panel 110 for the plurality of LEDs 1221 to enter into the plurality of first through holes H1 formed at the through hole type panel 110. Through the above-described assembly, the substrate 122 and the through hole type panel 110 may be spaced apart by a predetermined spacing distance by contacting with the bottom surface of the through hole type panel 110.

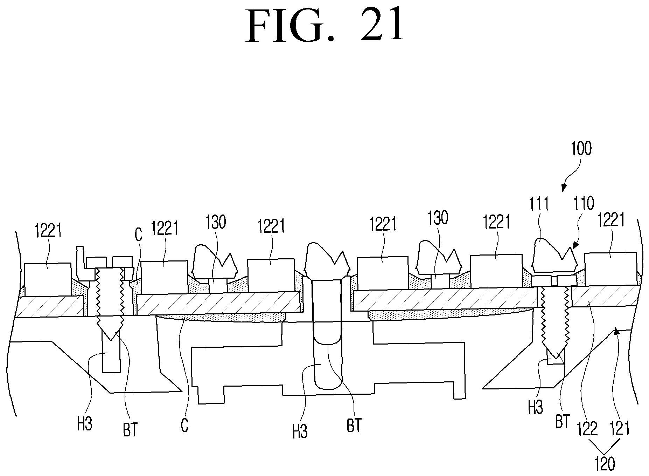

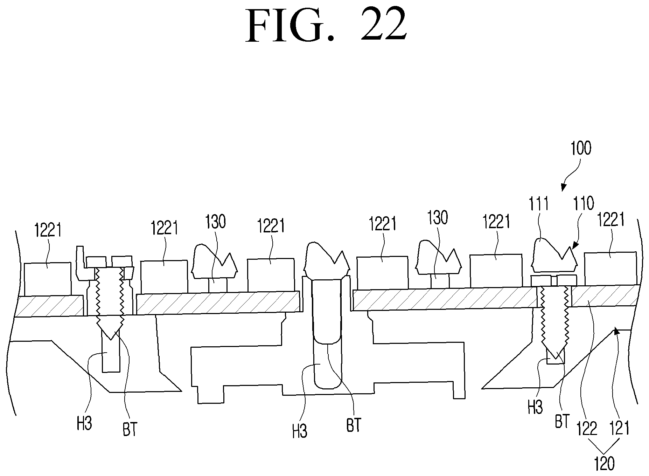

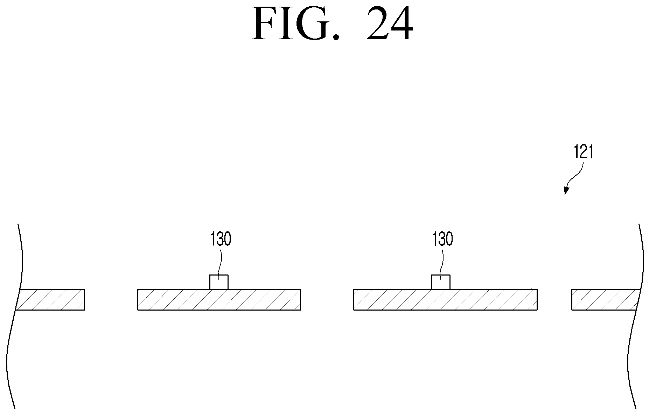

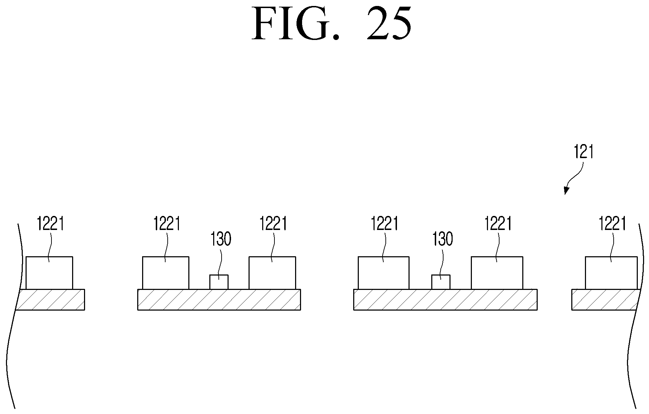

FIG. 21 to FIG. 25 are views schematically illustrating a cross-section of a display apparatus according to one or more embodiments of the disclosure. Referring to FIG. 14, FIG. 15, FIG. 21, and FIG. 22, the substrate 122 may be formed with a coating layer C at a position on a surface that includes the plurality of LEDs 1221 and the supporting reinforcement parts 130.

Here, the coating layer C may be formed with the supporting reinforcement part 130 installed on the substrate 122. The through hole type panel 110 may be formed with the first through holes H1. The substrate 122 may be formed with the second through holes H2 that correspond to the first through holes H1 (referring to FIG. 14 and FIG. 15).

The base panel 121 may be formed with third through holes H3 that correspond to the second through holes H2. The through hole type panel 110, the substrate 122, and the base panel 121 may be fixed through fixing members BT.

The supporting reinforcement parts 130 may have the spacing distance adjusted to correspond to the mounting of the fixing members BT. The first structure 1111 may be protruded from the top surface of the through hole type panel 110 in an upward direction, and positioned to divide the plurality of LEDs 1221.

More specifically, by sequentially passing through the through hole type panel 110, the substrate 122, and the base panel 121, the above may be fixed in the pressurized fixing method between one another through the fixing member BT.

Here, the fixing member BT may include members of a forceful insertion method or a screw turning coupling method. The supporting reinforcement part 130 may be installed on the substrate with a surface mount device (SMD) method, or the like. The supporting reinforcement part 130 may be provided in a shape in which a portion of one direction and a portion of the other direction corresponds to each other in a uniform form.

The coating layer C on the fixing member BT of the display apparatus 100 may be formed after the fixing members BT are fastened to relevant positions, or the fixing members BT are installed after the coating layer C is formed, and having the coating layer C formed again.

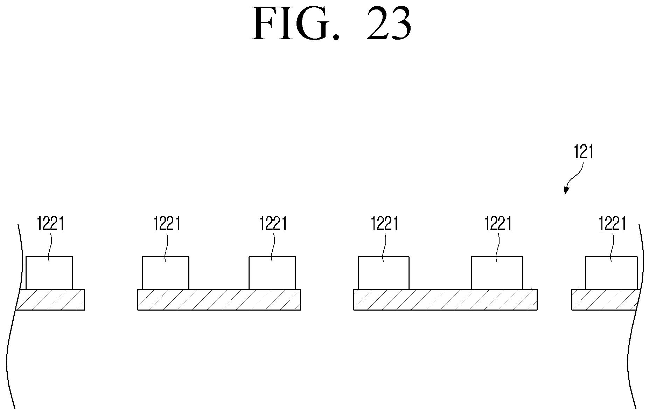

Referring to FIG. 23, FIG. 24, and FIG. 25, the display apparatus 100 may be configured such that the supporting reinforcement parts 130 are installed after the LEDs 1221 are first installed on the substrate 122. Alternatively, the LEDs 1221 may be installed after the supporting reinforcement parts 130 are installed on the substrate 122. The LEDs 1221 and the supporting reinforcement parts 130 being installed together on the substrate 122 may also be possible.

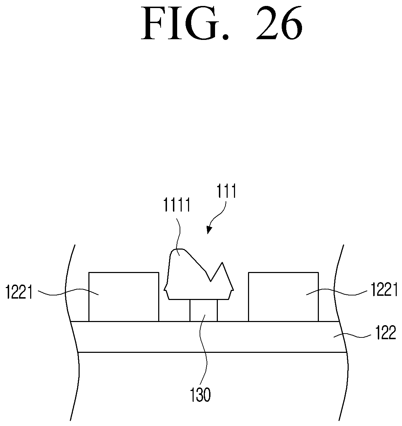

Referring to FIG. 26, the supporting reinforcement part 130 may support the body 111 of the through hole type panel 110 in a basically square or rectangular form, and perform support for the first structure 1111 and the like on the body 111.

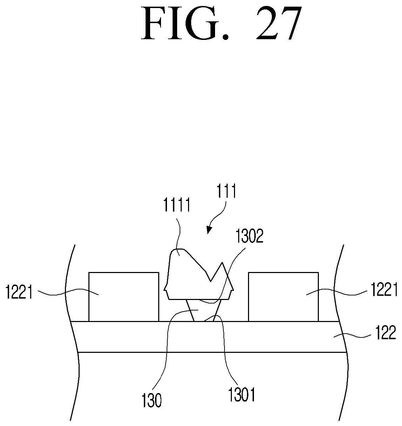

Referring to FIG. 27, as a deformation example of the supporting reinforcement part 130, the supporting reinforcement part 130 may be provided as a frustum type which includes a reduced part 1301 of which a portion in one direction is contacted on the substrate 122, and an expanded part 1302 of which a portion in the other direction is contacted on the body 111. That is, a side surface may correspond to a tapered state for an area of a cross-section of a portion that is in contact with the substrate 122 to be narrower than an area of a cross-section of a portion that is in contact with the through hole type panel 110. The supporting reinforcement part 130 may have column form with a cross-section that is circular or polygonal.

In this case, the supporting reinforcement part 130 may support the through hole type panel 110 by contacting the body 111 of the through hole type panel 110 with a wider area. Further, the spacing distance between the substrate 122 and the through hole type panel 110 as well as a contact area for the body 111 of the through hole type panel 110 may be relatively expanded.

Accordingly, a degree to which the upper direction of the through hole type panel 110 is rounded may be adjusted to be relatively more gentle. Here, a portion in one direction of the supporting reinforcement part 130 may contact the substrate 122 with a relatively reduced area than a portion in the other direction thereof such that focused pressing force is applied with respect to the substrate 122.

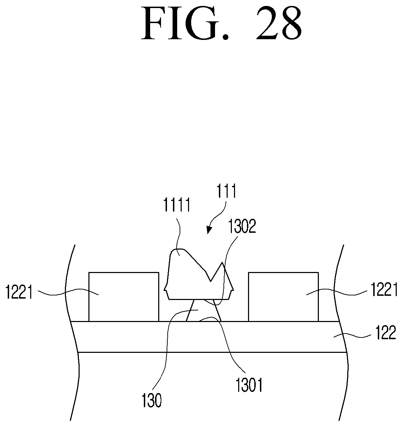

FIG. 28 is a view illustrating a portion of a substrate of a display apparatus as a modified example according to one or more embodiments of the disclosure. Referring to FIG. 28, as another deformation example of the supporting reinforcement part 130, the supporting reinforcement part may be provided as a frustum type which includes an expanded part 1301 of which a portion in one direction is contacted on the substrate 122, and a reduced part 1302 of which a portion in the other direction is contacted on the body 111.

Here, the supporting reinforcement part 130 of the display apparatus 100 may support the through hole type panel 110 by contacting the body 111 of the through hole type panel 110 with a narrower area.

Further, the spacing distance between the substrate 122 and the through hole type panel 110 as well as a contact area for the body 111 of the through hole type panel 110 may be relatively reduced. That is, the degree to which the upper direction of the through hole type panel 110 is rounded may be relatively adjusted to be more inclined.

Further, the portion in one direction of the supporting reinforcement part 130 may contact the substrate 122 with a relatively expanded area than a portion in the other direction thereof such that dispersed pressing force is applied with respect to the substrate 122.

The above allows for pressing force to be focused for the body 111 of the through hole type panel 110 while restricting load by an external force for the substrate 122. Specifically, if a thickness of the substrate 122 corresponds to a thin specification, the substrate 122 described above may be prevented from being damaged.

Further, if the supporting reinforcement parts 130 are contacted at a circuitry pattern formed on the substrate 130, a negative effect such as pressing force, damage, and the like being applied to the above-described circuitry pattern may be prevented.

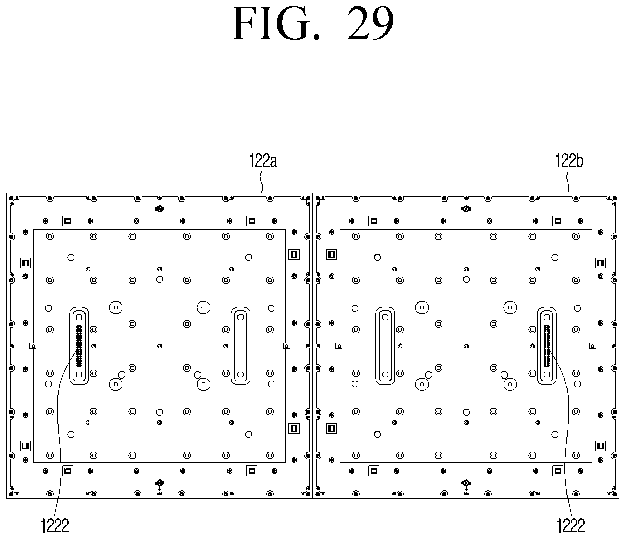

FIG. 29 is a view illustrating a state of arrangement of a display apparatus according to one or more embodiments of the disclosure. Referring to FIG. 29, the display apparatus may be provided in plurality.

The display apparatus 100 may be provided such that any one display apparatus 100 and another display apparatus 100 that corresponds to the any one display apparatus are adjacent with each other symmetrically.

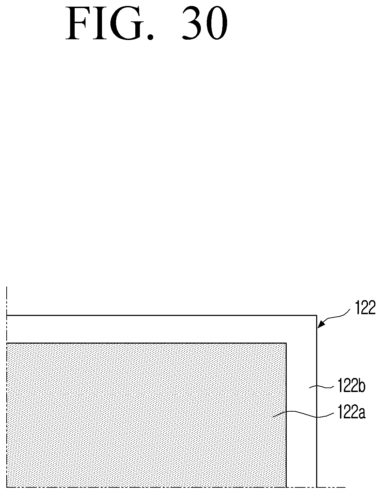

Referring to FIG. 30, the substrate 122 of the display apparatus 100 may include an inner zone 122a, and an outer zone 122b of each of an upper, lower, left and right portions at which application of the coating layer C is not performed that corresponds to the outer zone 122b of the above-described inner zone 122a.

Each edge portion from among the outer zone 122b of the substrate 122 may have a zone of a predetermined width. Here, the edge portion may include a quadrangular range, a width of which including values in a range of about 3.5 millimeters (mm) to about 4.5 mm in width and length, respectively. Here, the thickness value of the coating layer C may include values in a range of about 120 micrometers (*µ*m) to about 180 *µ*m, or the like.

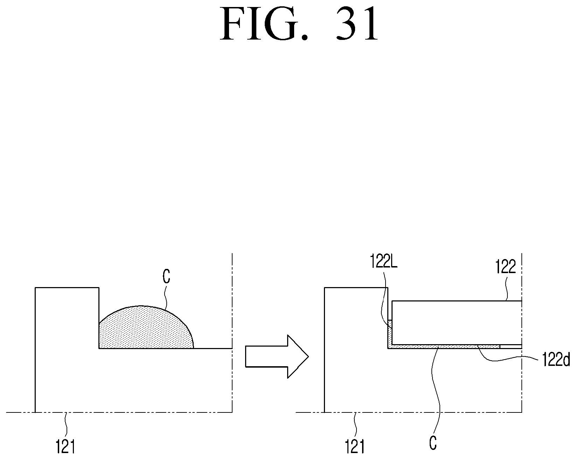

FIG. 31 is a view schematically illustrating a state in which a base panel and a substrate of a display apparatus are positioned according to one or more embodiments of the disclosure. Referring to FIG. 31, the coating layer C may be applied to the base panel 121, after which the substrate 122 may be installed on the base panel 121 applied with the coating layer C.

Through the above, a waterproofing process may be carried out between the base panel 121 and the substrate 122. The coating layer C may be formed through a spray method on a bottom surface space on the substrate 122 that opposes with the base panel 121 and a side surface space on the substrate 122 that opposes with the base panel 121.

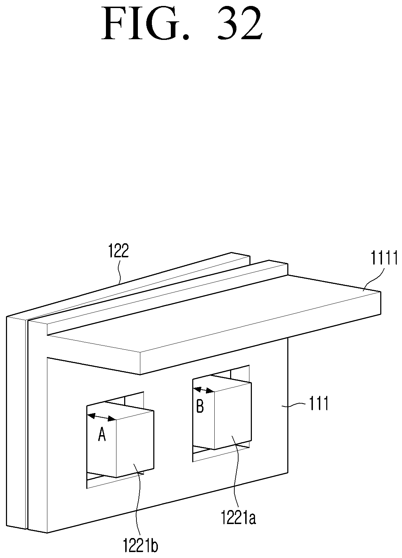

FIG. 32 and FIG. 34 are views illustrating a coupled state of a base panel, a substrate, and a through hole type panel while a supporting reinforcement part is missing. Referring to FIG. 12 and FIG. 32, the second structure 1112 may be protruded from the top surface of the through hole type panel 110 toward the upper direction, and positioned to divide the plurality of LEDs 1221 in the intersecting direction that intersects with the first structure 1111. The first structure 1111 and the second structure 1112 may be provided to surround the plurality of LEDs 1221.

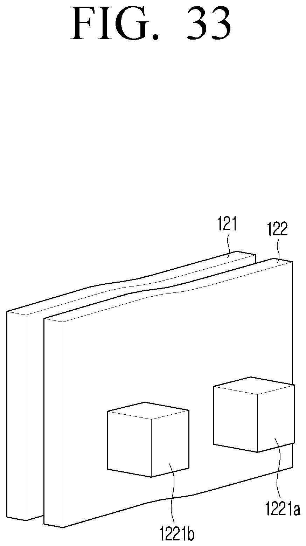

FIG. 33 is a view illustrating a coupled state of a base panel and a substrate. Referring to FIG. 32 and FIG. 33, a first LED 1221a and a second LED 1221b which are adjacent to each other from among the plurality of LEDs 1221 may be positioned in a different state from each another.

For example, due to the first LED 1221a and the second LED 1221b having an abnormal state between the through hole type panel 110, the substrate 122, and the base panel 121, and due to the coupled states between the above, the first LED 1221a may have a first degree of exposure A, and the second LED 1221b may have a second degree of exposure B.

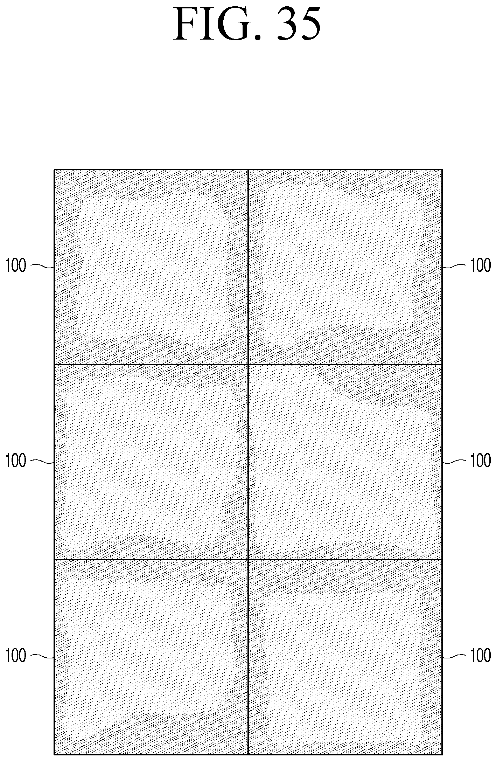

FIG. 35 is a view illustrating a state in which visibility of a display apparatus varies according to one or more embodiments of the disclosure. Referring to FIG. 34 and FIG. 35, the first LED 1221a may have the first degree of exposure A, the second LED 1221b may have a second degree of exposure B, and the first LED 1221a and the second LED 1221b described above may have different degrees to which the shadow zone (SZ) is formed by external light SL through the second substructure 1112.

Accordingly, a phenomenon in which visibility of each of the display apparatuses 100 vary may be generated. Even if there is no height difference between the plurality of LEDs 1221, the degree to which the shadow zone (SZ) is formed at the plurality of LEDs 1221 may vary according to at least one of the abnormal states from among the base panel 121, the substrate 122, and the through hole type panel 110.

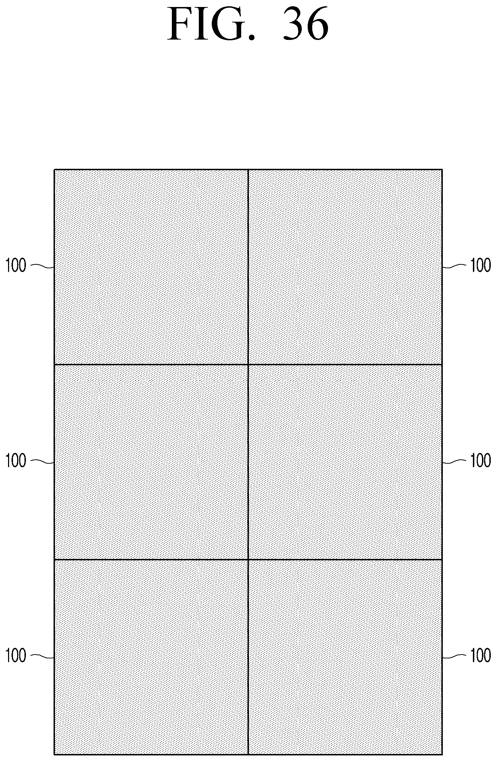

FIG. 36 is a view illustrating a state in which visibility of a display apparatus is uniform according to one or more embodiments of the disclosure. Referring to FIG. 36, by applying the supporting reinforcement part 130 of the display apparatus 100, a decrease in the above-described abnormal state may show that the visibility difference on the display apparatus 100 has been resolved.

The objects of the disclosure are not limited to the above-described objects, and other objects not mentioned above may be understood by one or ordinary skill in the art from the descriptions below. While the disclosure has been illustrated and described with reference to various embodiments thereof, it is to understand by one of ordinary skill in the art that various changes in form and details may be made therein without departing from the spirit and scope of the disclosure, including the appended claims and their equivalents.

## Claims

1. A display apparatus, comprising:
a through hole type panel;
a mounting module comprising a plurality of light emitting diodes (LEDs) and disposed on the mounting module to oppose the through hole type panel; and
a plurality of supporting reinforcement parts, each of the plurality of supporting reinforcement parts having a first portion, in a first direction, in contact with the through hole panel, and a second portion, in a second direction, in contact with the mounting module,
wherein the plurality of supporting reinforcement parts is configured to adjust a spacing distance between the through hole type panel and the mounting module.

2. The display apparatus of claim 1, wherein
the mounting module comprises
a substrate on which the plurality of LEDs are mounted, and
a base panel that accommodates the substrate inside thereof, and can be assembled with the through hole type panel.

3. The display apparatus of claim 2, wherein
the through hole type panel comprises a body comprising a first structure and a second structure that are positioned in intersecting directions between each other, and a plurality of first through holes corresponding to each of the plurality of LEDs is formed on the body.

4. The display apparatus of claim 3, wherein
at least one from among the plurality of supporting reinforcement parts is arranged alongside at one side of the plurality of LEDs on the substrate of the mounting module, and
based on the mounting module and the through hole type panel being assembled with each other for the plurality of LEDs to be arranged in the plurality of first through holes, the plurality of supporting reinforcement parts is contacted with a bottom surface of the through hole type panel from one side of the plurality of LEDs such that the substrate and the through hole type panel are spaced apart by a predetermined spacing distance.

5. The display apparatus of claim 4, wherein
the plurality of supporting reinforcement parts conform to a identifying a range in which a shadow zone is formed to be uniform between the plurality of LEDs, and
wherein the specification comprises a height value.

6. The display apparatus of claim 5, wherein the through hole type panel is mounted on the base panel using a pressurized fixing method,
wherein the through hole panel at least partially covers the substrate, and
wherein the plurality of supporting reinforcement parts are positioned on the substrate, and support the body of the through hole type panel corresponding to the pressurized fixing method.

7. The display apparatus of claim 6, wherein
the substrate comprises
a coating layer at least partially surrounding the plurality of supporting reinforcement parts at a position on a surface thereof comprising the plurality of LEDs and the supporting reinforcement parts.

8. The display apparatus of claim 7, wherein
the through hole type panel, the substrate, and the base panel are fixed by a fixing member in the pressurized fixing method.

9. The display apparatus of claim 8, wherein
the plurality of supporting reinforcement parts are installed on the substrate using a surface mount device (SMD) method, and
wherein the plurality of supporting reinforcement parts are on a region adjacent with a plurality of second through holes formed on the substrate.

10. The display apparatus of claim 2, wherein
the plurality of supporting reinforcement parts are disposed in a column form of which a cross-section thereof is circular or polygonal.

11. The display apparatus of claim 2, wherein
The plurality of supporting reinforcement parts are tapered at a side surface thereof for an area of a cross-section of a portion that contacts with the substrate to become wider than a cross-section of a portion that contacts with the through hole type panel.

12. The display apparatus of claim 2, wherein
The plurality of supporting reinforcement parts are tapered at a side surface thereof for an area of a cross-section of a portion that contacts the substrate to become narrower than a cross-section of a portion that contacts the through hole type panel.

13. The display apparatus of claim 3, wherein
the first structure protrudes from a top surface of the through hole type panel in an upward direction, and divides the LEDs,
the second structure protrudes from the top surface of the through hole type panel in the upward direction, and is positioned to divide the plurality of LEDs in an intersecting direction that intersects with the first structure, and
wherein the first structure and the second structure at least partially surround the plurality of LEDs.

14. The display apparatus of claim 13, wherein
one from among the first structure and the second structure protrudes higher than the other.

15. An assembly method of a display apparatus, the method comprising:
obtaining a mounting module by mounting a substrate on which a plurality of light emitting diodes (LEDs) is arranged on a base panel; and assembling a through hole type panel with the mounting module,
wherein the mounting module comprises
the plurality of LEDs arranged on the substrate and a plurality of supporting reinforcement parts, and
wherein the plurality of supporting reinforcement parts is configured to
based on the mounting module and the through hole type panel being assembled for the plurality of LEDs to be inserted in a plurality of first through holes formed on the through hole type panel, contact with a bottom surface of the through hole type panel from one side of the plurality of LEDs, and space apart the substrate and the through hole type panel by a predetermined spacing distance.
